# EUROPÄISCHE PATENTSCHRIFT

(11) **EP 3 664 046 B1**
(45) Veröffentlichungstag und Bekanntmachung des Hinweises auf die Patenterteilung: **10.08.2022**
(21) Anmeldenummer: 19207914.3
(22) Anmeldetag: 08.11.2019
(51) Int. Cl.: G07C 9/00, H03K 17/96, H01Q 1/32, H01Q 7/00, H03K 17/95

(54) **FAHRZEUGTÜRGRIFF MIT SENSOREINRICHTUNG UND DRAHTLOSER KOMMUNIKATIONSEINRICHTUNG**
VEHICLE DOOR HANDLE WITH SENSOR DEVICE AND WIRELESS COMMUNICATION DEVICE
POIGNÉE DE PORTE DE VÉHICULE DOTÉE D'UN DISPOSITIF CAPTEUR ET DISPOSITIF DE COMMUNICATION SANS FIL

(30) Priorität: 04.12.2018 DE 102018130789
(43) Veröffentlichungstag der Anmeldung: 10.06.2020
(73) Patentinhaber: HUF Hülsbeck & Fürst GmbH & Co. KG, 42551 Velbert (DE)
(72) Erfinder: CHABROWSKI, Christian, 45472 Mülheim (DE)
(74) Vertreter: Zenz Patentanwälte Partnerschaft mbB

(56) Entgegenhaltungen:
- WO-A1-2018/150106
- DE-A1-102013 102 701

## Beschreibung

Die Erfindung betrifft einen Fahrzeugtürgriff mit einer Sensorelektronik und einer Sende-/Empfangseinrichtung zur drahtlosen Kommunikation. Insbesondere betrifft die Erfindung einen Fahrzeugtürgriff bei dem in dem Fahrzeugtürgriff Komponenten der Sensorelektronik und Komponenten der Sende-/Empfangseinrichtung auf einer gemeinsamen Mehrlagenplatine ausgebildet sind. Diese Mehrlagenplatine ist in einem Abschnitt des Fahrzeugtürgriffes angeordnet der für einen Bediener als umgreifbare oder hintergreifbare Handhabe ausgebildet ist. Eine Steuerschaltung ist mit der Sensorelektronik und der Sende-/Empfangseinrichtung gekoppelt.

Fahrzeugtürgriffe mit Sensoren und Kommunikationseinrichtungen sind im Stand der Technik bekannt. Beispielsweise offenbart das Dokument WO 2015/180942 A1 eine Sensoreinrichtung für Kraftfahrzeuge, wobei eine Mehrlagenplatine in einer Handhabe eines Fahrzeugtürgriffes untergebracht ist. Auf den verschiedenen Ebenen der Mehrlagenplatine sind Elektrodenbereiche ausgebildet, die mit einer Steuerschaltung gekoppelt sind. Um unterschiedliche Erfassungsrichtungen und Sensitivitäten der Erfassung realisieren zu können, werden die Elektroden mit wechselnden Funktionen im Multiplexbetrieb angesteuert, beispielsweise zeitweise als Sensorelektrode, zeitweise als Referenzelektrode und zeitweise als Shield-Elektrode. Dadurch bildet die Sensoreinrichtung ein kapazitives Erfassungssystem, dessen Anwendung insbesondere in sogenannten Keyless-Entry-Systemen von Fahrzeugen bekannt ist.

Bekannte Fahrzeugtürgriffe enthalten neben solchen Sensoranordnungen auch Antennenstrukturen, insbesondere Sendeantennen zur Aussendung eines Weck- und Erkennungssignals für Keyless-Entry-Systeme. Solche Antennensysteme sind häufig für die Aussendung von Signalen im Bereich von 125 kHz ausgebildet. Zunehmend werden jedoch auch Kommunikationseinrichtungen mit Sende-/Empfangseinrichtungen in Fahrzeugtürgriffen untergebracht, die eine hochfrequente Kommunikation, insbesondere Nahfeldkommunikation zwischen einem mobilen Gerät und der Sende-/Empfangseinrichtung im Fahrzeugtürgriff ermöglichen. Die Kombination solcher Sende-/Empfangseinrichtungen und der zusätzlichen Sensorik im Fahrzeugtürgriff bringt jedoch Probleme mit sich, da die von den verschiedenen elektronischen Komponenten erzeugten Felder andere Komponenten in Ihrer Funktion beeinträchtigen können und/oder die Ausbreitung der elektromagnetischen Felder beeinträchtigt wird.

Aus dem Dokument DE 10 2013 102 701 A1 ist eine Türgriffanordnung für ein Kraftfahrzeug mit kapazitivem Näherungssensor und NFC-Sende-/Empfangseinheit bekannt. Eine Sensorelektrode ist als NFC-Antennenspule ausgebildet und deren Anschlüsse sind über eine Koppelschaltung mit dem NFC-Baustein koppelbar.

Die WO 2018/150106 A1 beschreibt ein Verfahren zur Erfassung eines Benutzers mittels eines Türgriffs, wobei eine kontinuierliche Messung der Resonanzfrequenz der Erfassungsvorrichtung und ein Vergleich mit einer ersten Schwelle durchgeführt wird.

Aufgabe der Erfindung ist es, einen Fahrzeugtürgriff mit einer kompakten Sensorelektronik und Sende-/Empfangseinrichtung zur Verfügung zu stellen.

Diese Aufgabe wird durch einen Fahrzeugtürgriff mit den Merkmalen des Patentanspruches 1 gelöst.

Der erfindungsgemäße Fahrzeugtürgriff weist als Komponente der Sende-/Empfangseinrichtung eine Nahfeldspule als Antenne auf, die auf einer ersten Ebene der Mehrlagenplatine ausgebildet ist.

Die Nahfeldspule kann insbesondere als gedruckte Leiterbahn auf der ersten Ebene der Mehrlagenplatine ausgebildet sein. Unter einer ersten Ebene ist eine beliebige Ebene der Mehrlagenplatine zu verstehen, welche zur Aufbringung von Leiterbahnen geeignet ist. Insbesondere kann dies eine äußere Deckseite oder eine der innenliegenden Ebenen der Mehrlagenplatine sein. Die Sensorelektronik des erfindungsgemäßen Fahrzeugtürgriffes weist wenigstens einen induktiven Sensor auf, der auf einer zweiten Ebene der Mehrlagenplatine ausgebildet ist. Induktive Sensoren sind im Markt als konfigurierte Bauteile verfügbar oder können durch Anordnung von Induktivitäten, insbesondere Spulenstrukturen, die durch gedruckte Leiterbahnen gebildet sind, zu einem oszillierenden System auf einer Ebene der Mehrlagenplatine ausgebildet sein. Die zweite Ebene ist eine andere Ebene als die erste Ebene der Mehrlagenplatine, so dass ein Abstand zwischen der ersten Ebene der Mehrlagenplatine und der zweiten Ebene der Mehrlagenplatine vorhanden ist.

Weiterhin ist eine erste Elektrodenfläche auf der Mehrlagenplatine in einem Flächenbereich ausgebildet, der von der Nahfeldspule umschlossen wird. Die Umschließung ergibt sich dabei in einer Projektion in Richtung senkrecht zu den Lagen der Mehrlagenplatine, also in einer Richtung senkrecht zu den Deckflächen. Es wird auf die Projektion der Komponenten abgestellt, da die Nahfeldspule und die Elektrodenflächen auf unterschiedlichen Ebenen der Mehrlagenplatine liegen können und die Umschließung daher auf verschiedenen Ebenen erfolgt. Bei einer Sichtrichtung in senkrechter Richtung zu den Ebenen der Mehrlagenplatine wird die Elektrodenfläche vollständig von der Nahfeldspule umlaufen.

Außerdem ist die Elektrodenfläche so angeordnet, dass der Flächenbereich der Elektrodenfläche den wenigstens einen induktiven Sensor in einer Projektionsrichtung in Richtung senkrecht zu den Lagen der Mehrlagenplatine wenigstens teilweise abdeckt. In derselben Sichtrichtung wie zuvor erläutert, also senkrecht zu den Ebenen der Mehrlagenplatine, liegt der induktive Sensor wenigstens teilweise (zu mehr als 50% und bevorzugt vollständig) oberhalb oder unterhalb der ersten Elektrodenfläche. Die erste Elektrodenfläche ist in der Mehrlagenplatine entweder auf der ersten Ebene, also der Ebene mit der Nahfeldspule der Sende-/Empfangseinrichtung angeordnet, oder einer Ebene zwischen dieser ersten Ebene und der zweiten Ebene, die den wenigstens einen induktive Sensor trägt.

Diese Gestaltung ermöglicht eine Abschirmung der elektromagnetischen Felder der Nahfeldspule von den elektromagnetischen Feldern des induktiven Sensors - und umgekehrt. Induktive Sensoren weisen ebenfalls Spulenwindungen auf, so dass sich die elektromagnetischen Felder der induktiven Komponenten im Betrieb überlagern und stören können und ein verlässlicher Betrieb der Komponenten nicht mehr möglich ist. Auch wenn die Komponenten, also die Nahfeldspule einerseits und der induktive Sensor andererseits, zeitversetzt betrieben werden, stellen sie dennoch Bauelemente dar, die bei Aktivierung Spannungen in dem jeweils anderen Bauteil induzieren und Energie aufnehmen können. Durch den Flächenbereich der ersten Elektrodenfläche, der den induktiven Sensor teilweise oder vollständig überdeckt und dessen Anordnung im Inneren der Windung der Nahfeldspule wird eine kompakte Bauweise und ein störungsarmer Betrieb ermöglicht.

Der induktive Sensor wird nämlich in derselben Baufläche angeordnet, die von der Nahfeldspule umlaufen wird, wodurch ein platzsparender Aufbau ermöglicht ist. Die erste Elektrodenfläche verhindert ein Durchgreifen der elektromagnetischen Felder von der Nahfeldspule der Nahfeldantenne in den induktiven Sensor einerseits und von dem induktiven Sensor in die Nahfeldspule andererseits. Dabei kann die erste Elektrodenfläche durchaus in derselben ersten Ebene angeordnet sein wie die Nahfeldspule der Nahfeldantenne. Dies ist insbesondere dann vorteilhaft, wenn eine Platine mit wenigen Lagen zum Einsatz kommt. Die Elektrodenfläche braucht in dieser Gestaltung nicht den gesamten Flächenbereich auszufüllen, in welchem sie angeordnet und ausgebildet ist. Stattdessen kann die Elektrodenfläche auch strukturiert sein, insbesondere um die Ausbildung von Wirbelströmen in der Elektrodenfläche zu reduzieren. Dies kann erreicht werden, indem die Elektrodenfläche aus galvanisch gekoppelten Leiterbereichen gebildet ist, die jedoch keine zusammenhängenden Flächen bilden, in welchen sich relevante Wirbelströme ausbilden können.

Die erfindungsgemäße Konstruktion erlaubt es, in einem Fahrzeugtürgriff sowohl induktive Sensoren anzuordnen als auch eine Sende-/Empfangseinrichtung mit einer Nahfeldantenne, wobei der Bedarf an Bauraum gegenüber herkömmlichen Systemen nicht vergrößert ist. Dabei können auch mehrere induktive Sensoren in einer Anordnung auf der Mehrlagenplatine ausgebildet sein, die sämtlich teilweise - oder vollständig - von der ersten Elektrodenfläche in der geschilderten Weise abgedeckt werden.

Der Abstand in Richtung der Ebenen der Mehrlagenplatine zwischen der ersten Elektrodenfläche und der Nahfeldspule ist so zu wählen, dass die Felderzeugung der Nahfeldantenne zur verlässlichen Kommunikation über die Sende-/Empfangseinrichtung gewährleistet ist. Es kann vorgesehen sein, dass die erste Elektrodenfläche mit einem Bezugspotenzial, beispielsweise der Fahrzeugmasse gekoppelt ist, oder dass diese Elektrodenfläche ohne Potenzialvorgabe, also mit Float-Potenzial betrieben wird.

In einer Weiterbildung der Erfindung wird die erste Ebene durch eine erste äußere Deckebene der Mehrlagenplatine gebildet und die zweite Ebene wird durch die zweite äußere Deckebene der Mehrlagenplatine gebildet, welche auf der der ersten äußeren Deckebene abgewandten Seite der Mehrlagenplatine ausgebildet ist. Die erste Ebene einerseits und die zweite Ebene andererseits sind dann die beiden, voneinander abgewandten Deckseiten der Mehrlagenplatine. Auf der einen Seite, die im Einbau im Fahrzeugtürgriff beispielsweise zu einer Außenseite des Türgriffes orientiert ist, kann die erste Ebene zu liegen kommen. Dann kann ein Benutzer mit einem mobilen Kommunikationsgerät problemlos dieses Kommunikationsgerät an die Außenseite, also die ihm zugewandte Seite und dem Fahrzeug abgewandte Seite des Fahrzeugtürgriffes annähern und eine Nahfeldkommunikation zwischen dem Mobilgerät und der Sende-/Empfangseinrichtung im Fahrzeugtürgriff initiieren. Diese Seite ist der Nahfeldspule nächstliegend. Auf der anderen Seite der Mehrlagenplatine, die dann dem Fahrzeug zugewandt ist, ist der induktive Sensor angeordnet, um eine Betätigung des Fahrzeugtürgriffes zu erfassen. Die Erfassung von Türgriffbetätigungen durch induktive Sensoren ist dabei grundsätzlich bekannt, wobei regelmäßig ein metallisches Material, welches sich am Türgriffgehäuse befindet oder mit diesem gekoppelt ist, in seiner Lage gegenüber dem induktiven Sensor verändert wird. Dies kann beispielsweise geschehen, indem eine metallische Beschichtung auf den Fahrzeugtürgriff aufgebracht ist, welche sich beim Ziehen am Türgriff gegenüber dem innen auf der Platine angeordneten induktiven Sensor verschiebt. Die Veränderung der erfassten Induktivität des induktiven Sensors kann als Maß für eine Lageveränderung ausgewertet werden.

Auf die dargestellte Weise sind die Nahfeldspule der Sende-/Empfangseinrichtung einerseits und der induktive Sensor andererseits im größtmöglichen Abstand in einer Richtung senkrecht zu den Platinenebenen angeordnet. Diese Anordnung stellt eine optimal verringerte gegenseitige Beeinflussung der induktiven Elemente sicher.

Gemäß einer Weiterbildung der Erfindung ist die erste Elektrodenfläche mit der Steuerschaltung gekoppelt, wobei ein elektrisches Potenzial der ersten Elektrodenfläche von der Steuerschaltung vorgebbar ist.

Die Steuerschaltung kann, je nach Betriebsmodus des Fahrzeugtürgriffes, die Potenzialvorgabe für die erste Elektrodenfläche ändern. Dadurch kann beispielsweise eine gezielte Schirmungswirkung bei Betrieb des induktiven Sensors einerseits und bei Betrieb der Sende-/Empfangseinrichtung mit der Nahfeldantenne andererseits erreicht werden. Die Steuerschaltung kann dabei auch so ausgebildet sein, dass neben einer gezielten Potenzialvorgabe, beispielsweise entsprechend einer Fahrzeugmasse, auch die Entkopplung zum Betrieb auf Float-Potenzial wenigstens zeitweise realisiert wird. Bei Kopplung der Elektrodenfläche mit der Steuerschaltung ist daher die zeitliche Veränderung der Potenzialvorgabe für die Elektrodenfläche möglich.

In einer bevorzugten Ausführungsform der Erfindung ist die erste Elektrodenfläche mit der Steuerschaltung als kapazitive Sensorelektrode wirksam gekoppelt.

Der Mehrzweck einer Nutzung der ersten Elektrodenfläche als kapazitive Sensorelektrode einerseits und Elektrode zur Schirmung der induktiven Komponenten voneinander andererseits erlaubt es, einen Fahrzeugtürgriff mit Sende-/Empfangseinrichtung, kapazitivem Sensor und induktivem Sensor bereitzustellen, ohne zusätzlichen Bauraum zu erfordern. Damit wird ein äußerst kompakter und multifunktionaler Aufbau realisiert.

In einer Weiterbildung dieser Ausführungsform ist die Elektrodenfläche mit einer Mehrzahl von beabstandeten Leiterbahnen ausgebildet, die sich in derselben Fläche erstrecken und jeweils an einem Ende galvanisch zur Bildung der ersten Elektrodenfläche gekoppelt sind. Wie bereits vorstehend erläutert, kann eine derartige Ausbildung der Elektrodenfläche mit Verzweigungen und beabstandeten Leiterbahnen die Ausbildung Von Wirbelströmen in der Elektrodenfläche verringern, was sich positiv auswirken kann, wenn eine gegenseitige Beeinflussung aus Induktivität und Elektrodenfläche in bestimmten Betriebsmodi reduziert werden soll. Eine entsprechende Gestaltung von kapazitiven Sensorflächen ist z.B. in dem Dokument WO 2018 177580 offenbart.

Es hat sich gezeigt, dass auch eine solche Ausführungsform die Entkopplung der beiden Induktivitäten voneinander gewährleisten kann, insbesondere wenn die erste Elektrodenfläche mit einem Schirmpotenzial betrieben wird. In einem solchen Fall macht die Ausbildung der Elektrodenfläche mit Verzweigungen einen ähnlichen Abschirmeffekt wie bei einer durchgehenden, rechteckigen, polygonalen oder elliptischen Fläche.

In einer bevorzugten Ausführungsform einer solchen Elektrodenfläche mit beabstandeten Leiterbahnen sind diese Leiterbahnen in einer Kammstruktur parallel zueinander angeordnet und durch einen einseitigen Verbindungsleiter miteinander gekoppelt. Eine entsprechende Gestaltung von kapazitiven Sensorflächen ist wiederum in dem Dokument WO 2018 177580 offenbart.

Eine solche Kammstruktur oder Grätenstruktur ist besonders einfach zu fertigen und kann auch, ausgehend von dem Verbindungsleiter, zu beiden Seiten des Verbindungsleiters ausgebildet werden, so dass eine beidseitige Grätenstruktur von dem Verbindungsleiter ausgeht.

In einer weiteren Ausführungsform der Erfindung ist in der zweiten Ebene der Mehrlagenplatine, also der Ebene des induktiven Sensors, eine zweite Elektrodenfläche ausgebildet, welche um den wenigstens einen induktiven Sensor herum angeordnet ist. Dabei ist der Flächenbereich der zweiten Elektrodenfläche ebenfalls von der Spulenwindung in einer Projektionsrichtung in Richtung senkrecht zu den Lagen der Mehrlagenplatine umschlossen. Die zweite Elektrodenfläche ist mit der Steuerschaltung als kapazitive Sensorelektrode wirksam gekoppelt.

In dieser Gestaltung sind eine erste Elektrodenfläche sowie eine zweite Elektrodenfläche vorgesehen. Die zweite Elektrodenfläche ist eine Sensorelektrode und belegt Platz in derselben Ebene wie der induktive Sensor, wobei sie den vom induktiven Sensor nicht belegten Raum einnimmt und nutzt. Die erste Elektrodenfläche hingegen übernimmt die Schirmwirkung zur Unterbindung der gegenseitigen Beeinflussung der induktiven Elemente, also der Nahfeldspule der Sende-/Empfangseinrichtung einerseits und des induktiven Sensors andererseits.

Grundsätzlich kann jede der vorgenannten Ausführungsformen mit oberflächenmontierbaren induktiven Sensoren realisiert werden, alternativ und bevorzugt kann jedoch der induktive Sensor mit einer gedruckten spiralförmigen Spulenwicklung auf der Mehrlagenplatine ausgebildet sein. Auf diese Weise ist der induktive Sensor in besonders platzsparender und günstiger Weise bereitzustellen und beim Herstellungsprozess der Platine ohne Bestückung durch zugekaufte Komponenten herstellbar.

Die Erfindung wird nun anhand der beiliegenden Zeichnungen näher erläutert.
Figur 1 zeigt schematisch einen erfindungsgemäßen Fahrzeugtürgriff mit Bedienerzugriff;
Figur 2a zeigt schematisch die Anordnung von elektronischen Komponenten auf einer Mehrlagenplatine gemäß einer ersten Ausführungsform der Erfindung;
Figur 2b zeigt die Anordnung aus Figur 2a in einer schematischen Seitenansicht;
Figur 3a zeigt schematisch die Anordnung von elektronischen Komponenten auf einer Mehrlagenplatine gemäß einer zweiten Ausführungsform der Erfindung;
Figur 3b zeigt die Anordnung aus Figur 3a in einer schematischen Seitenansicht;
Figur 4a zeigt schematisch die Anordnung von elektronischen Komponenten auf einer Mehrlagenplatine gemäß einer dritten Ausführungsform der Erfindung;
Figur 4b zeigt die Anordnung aus Figur 4a in einer schematischen Seitenansicht;
Figur 4c zeigt die Anordnung aus den Figuren 4a und 4b von unten;
Figur 5a zeigt schematisch die Anordnung von elektronischen Komponenten auf einer Mehrlagenplatine gemäß einer vierten Ausführungsform der Erfindung;
Figur 5b zeigt die Anordnung aus Figur 5a in einer schematischen Seitenansicht;

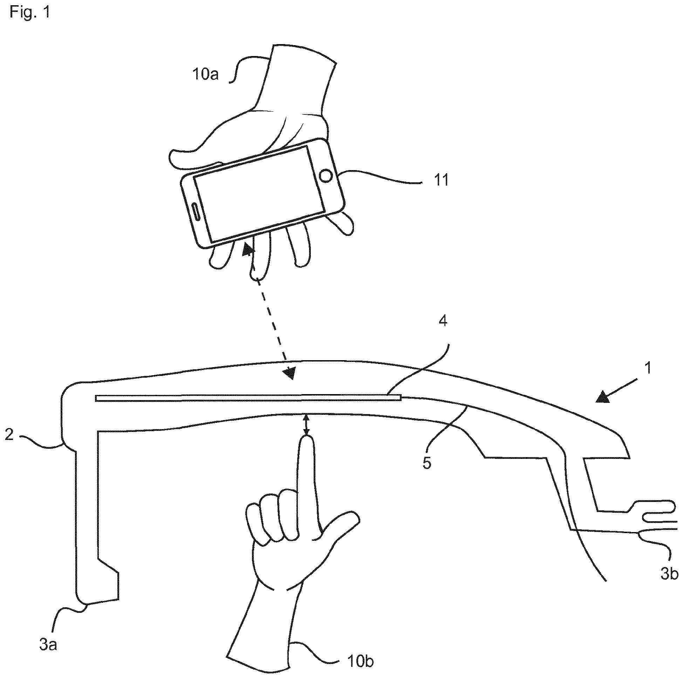

In Figur 1 ist ein Fahrzeugtürgriff 1 dargestellt, der eine Handhabe 2 aufweist, welche bei Montage am Fahrzeug auf der Außenseite der Fahrzeugtür angeordnet ist und einen Benutzer zur Betätigung zur Verfügung steht. An der Handhabe 2 sind Kopplungsabschnitte 3a und 3b zur mechanischen Kopplung der Handhabe 2 an einem Griffträger (nicht gezeigt) am Fahrzeug angeordnet. Eine Mehrlagenplatine 4 ist in der Handhabe aufgenommen, so dass sie mit einer ihrer Deckseiten zu einer Außenseite, in Figur 1 nach oben, ausgerichtet ist und mit einer abgewandten Deckseite der Mehrlagenplatine 4 zu einer Innenseite, in Figur 1 nach unten. Die Innenseite der Handhabe 2 liegt bei Montage am Fahrzeug gegenüber dem Fahrzeugtürblech, die Außenseite der Handhabe ist der Umgebung zugewandt. Über einen Kabelbaum 5 ist die Mehrlagenplatine 4 von Fahrzeugseite aus koppelbar.

In Figur 1 sind zwei verschiedene Wechselwirkungsmöglichkeiten eines Benutzers 10a, 10b mit dem Fahrzeugtürgriff 1 dargestellt. Nähert sich ein Benutzer 10a mit einem Mobilgerät 11 mit Fähigkeit zur NFC-Kommunikation der Außenseite des Fahrzeugtürgriffes 1 an, kann bei ausreichender Annäherung zwischen einer Sende-/Empfangseinrichtung auf der Mehrlagenplatine 4 und dem Mobilgerät 11 eine Nahfeldkommunikation etabliert werden. Dazu wechselwirken die Felder einerseits der Sende-/Empfangseinrichtung des Mobilgerätes 11 und andererseits der Sende-/Empfangseinrichtung auf der Mehrlagenplatine 4. Auf der Innenseite der Handhabe 2 des Fahrzeugtürgriffes 1 kann ein Benutzer 10b manuell auf den Türgriff einwirken. Auf dieser Seite der Mehrlagenplatine 4 ist wenigstens ein induktiver Sensor angeordnet, der Verformungen der Handhabe 2 durch Krafteinwirkung des Benutzers 10b erfassen kann. Bei Krafteinleitung durch den Benutzer 10b wird nämlich das Gehäuse der Handhabe 2 geringfügig verformt, was ein induktiver Sensor auf der im Fahrzeugtürgriff 1 ortsfest aufgenommenen Platine 4 detektiert. Dafür kann die Handhabe 2 außen oder innen mit einer metallischen Schicht belegt sein oder es kann ein metallisches Element auf der Innenseite der Handhabe 2, gegenüber von dem induktiven Sensor auf der Mehrlagenplatine 4 angeordnet sein.

Anhand der Figur wird deutlich, dass dieselbe Mehrlagenplatine 4 sowohl eine Kommunikationsfunktion ermöglicht, als auch eine Sensierung einer händischen Betätigung. Die verschiedenen Betriebsmodi können dabei zeitlich versetzt erfolgen, so dass jeweils immer nur eine Funktionalität aktiv ist, entweder der Sende-/Empfangsbetrieb oder der Sensierungsbetrieb.

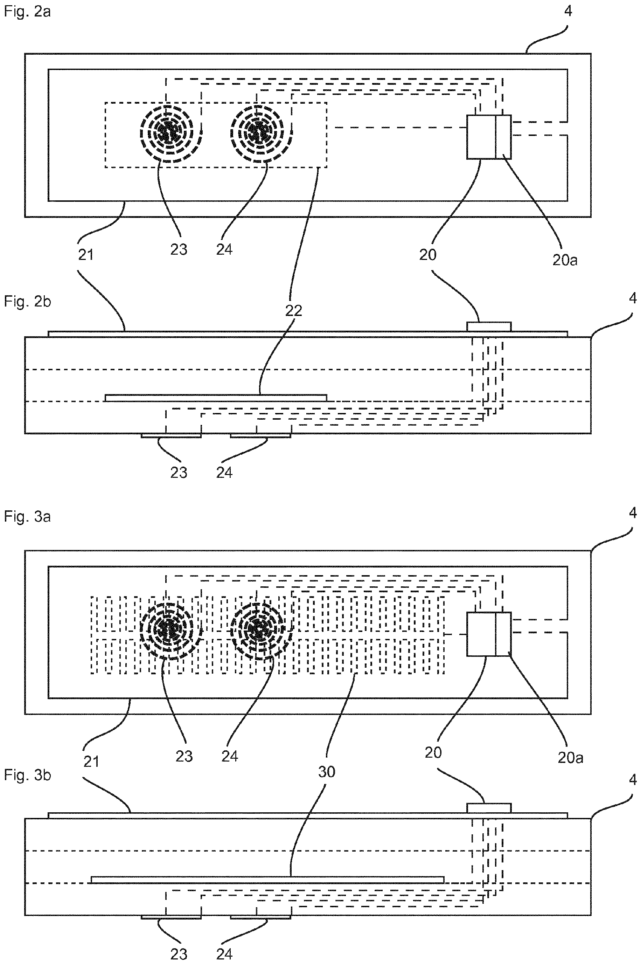

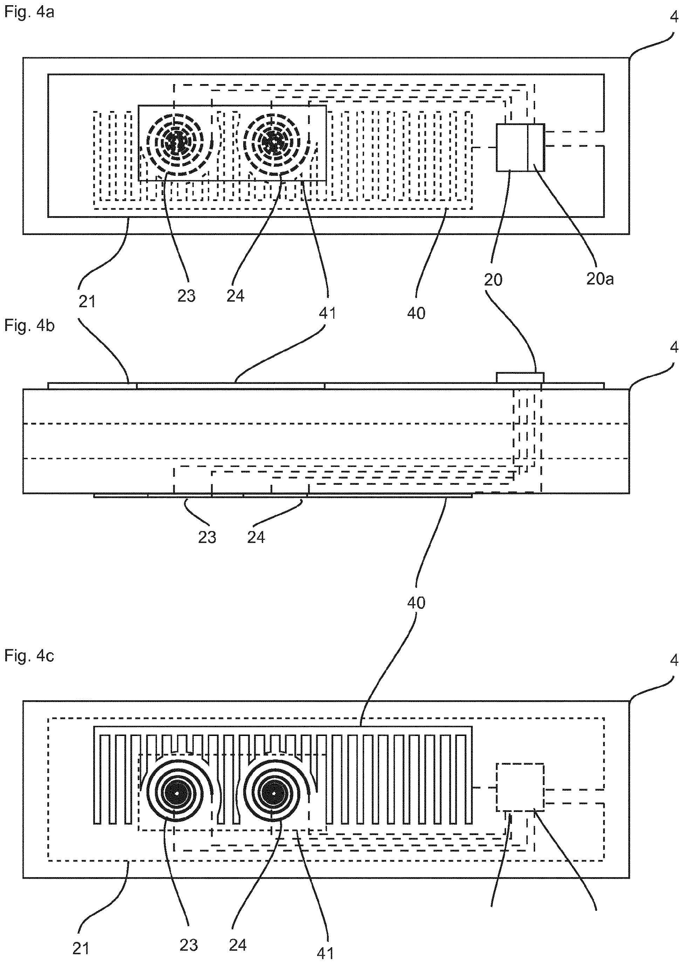

Während Figur 1 die Anordnung einer Mehrlagenplatine 4 in der Handhabe 2 eines Fahrzeugtürgriffes 1 zeigt, stellen die drei Ausführungsbeispiele in den Figuren 2a, 2b (erstes Ausführungsbeispiel), den Figuren 3a, 3b (zweites Ausführungsbeispiel) und den Figuren 4a, 4b (drittes Ausführungsbeispiel) unterschiedliche Möglichkeiten der Anordnung der Funktionskomponenten auf der Mehrlagenplatine 4 in einem erfindungsgemäßen Türgriff dar. Die in diesen Ausführungsbeispielen dargestellte Mehrlagenplatine 4 weist vier Ebenen auf, wobei die erste und die vierte Ebene Deckebenen der Mehrlagenplatine 4 sind und zwei innere Funktionsebenen der Mehrlagenplatine 4 ausgebildet sind. Eine Steuereinrichtung 20 ist auf einer ersten Ebene der Mehrlagenplatine 4 angeordnet, wobei diese erste Ebene die obere Deckebene bildet. Die Orientierung ist dabei gleichbleibend zu der Figur 1, die nach oben weisende Seite der Mehrlagenplatine aus den Ausführungsbeispielen liegt auch in Figur 1 nach oben, also der Außenseite des Fahrzeugtürgriffes 1 zugewandt.

Die Figuren 2a und 2b zeigen eine erste Ausführungsform einer Mehrlagenplatine 4. Auf der ersten Ebene der Mehrlagenplatine 4 ist eine Nahfeldspule 21 der Sende-/Empfangseinrichtung ausgebildet. Diese Nahfeldspule 21 ist mit der Steuerschaltung 20 gekoppelt. Die Sende-/Empfangseinrichtung weist Komponenten auf, die mit der Steuerschaltung 20 integriert sind, zusätzlich zu der Nahfeldspule 21. Diese mit der Steuerschaltung 20 integrierten Komponenten der Sende-/Empfangseinrichtung sind mit dem Bezugszeichen 20a gekennzeichnet. Die Sende-/Empfangseinrichtung und die Steuerschaltung 20 können auch als gekoppelte, getrennte elektronische Komponenten ausgebildet und auf der Mehrlagenplatine 4 angeordnet sein.

In einer zweiten Ebene der Mehrlagenplatine 4, nämlich der unteren Deckseite der Mehrlagenplatine, sind zwei gedruckte spiralförmige Spulenwindungen 23 und 24 als induktive Sensoren angeordnet. Diese induktiven Sensoren 23 und 24 sind mit der Steuerschaltung 20 gekoppelt. Die Steuerschaltung 20 steuert die induktiven Sensoren 23 und 24 an, um Veränderungen von deren Induktivität bei Verformung des Gehäuses des Fahrzeugtürgriffes 1 zu erfassen.

Auf einer Ebene zwischen der ersten Ebene der Mehrlagenplatine 4 und der zweiten Ebene der Mehrlagenplatine 4, also zwischen den Deckseiten der Mehrlagenplatine, ist eine Elektrodenfläche 22 angeordnet, die ebenfalls mit der Steuerschaltung 20 gekoppelt ist. Die Steuerschaltung 20 kann das Potenzial der Elektrodenfläche 22 vorgeben. Diese Elektrodenfläche 22 wirkt bei geeigneter Potentialvorgabe als Schirmelektrode, welche die gegenseitige Beeinflussung der Induktivitäten der Nahfeldspule 21 einerseits und der induktiven Sensoren 23 und 24 anderseits vermindert.

In Figur 2b ist ersichtlich, dass die Elektrodenfläche 22 in einer Ebene angeordnet ist, die näher zu den induktiven Sensoren 23 und 24 liegt als zu der Nahfeldspule 21. Dadurch wird die Schirmwirkung für die induktiven Sensoren 23 und 24 verbessert. Außerdem ist in Figuren 2a und 2b ersichtlich, dass die Nahfeldspule 21 vollständig um die Elektrodenfläche 22 umläuft und die Elektrodenfläche 22 wiederum die induktiven Sensoren 23 und 24 abdeckt. Dies ist insbesondere in Figur 2a zu erkennen, welche eine Sichtrichtung senkrecht zu den Ebenen der Mehrlagenplatine darstellt.

Je nach Einsatz und gewünschter Funktion, kann die Steuerschaltung 20 das Potenzial der Elektrodenfläche 22 vorgeben oder die Elektrodenfläche 22 auf Float-Potenzial legen. Die Vorgabe eines Potenzials, beispielsweise eines Massepotenzials, verbessert die Schirmwirkung gegenüber Feldern, die sich in Richtung der Elektrodenfläche 22 erstrecken.

Die Figuren 3a und 3b zeigen eine alternative Gestaltung, wobei gegenüber dem vorherigen Ausführungsbeispiel die geometrische Form der Elektrodenfläche 30 geändert wurde. Die Elektrodenfläche 30 bildet in dieser Ausführungsform eine doppelte Kammstruktur oder Fischgrätenstruktur, wobei die Ausbildung von Wirbelströmen durch die Formgebung reduziert wird. Die Elektrode 30 kann aufgrund ihrer räumlichen Ausdehnung zusätzlich zu den induktiven Sensoren 23 und 24 von der Steuerschaltung 20 als kapazitive Sensorelektrode zur Erfassung von Annäherungen an den Fahrzeugtürgriff 1 verwendet werden. Außerdem kann die Elektrodenfläche 30 durch geeignete Potenzialvorgabe durch die Steuerschaltung 20 als Shield-Elektrode fungieren, um eine Entkopplung der Felder der induktiven Komponenten 21 einerseits und 23 und 24 andererseits zu bewirken.

Die Figuren 4a und 4b zeigen eine weitere, dritte Ausführungsform der Erfindung. In dieser Gestaltung ist eine kapazitive Sensorelektrode 40 auf der zweiten Ebene der Mehrlagenplatine 4 angeordnet, also auf derselben Ebene wie die induktiven Sensoren 23 und 24. Figur 4c zeigt die Anordnung aus den Figuren 4a und 4b in einer schematischen Ansicht von unten.

Diese Sensorelektrode 40 kann als kapazitiver Sensor von der Steuerschaltung 20 angesteuert werden. Die kammartige Struktur der Sensorelektrode 40 bettet die induktiven Sensoren 23 und 24 ein und umläuft diese, um eine negative gegenseitige Störung auszuschließen. Zusätzlich ist eine Schirmelektrode 41 in der ersten Ebene der Mehrlagenplatine ausgebildet, also in derselben Ebene wie die Antennenspule 21. Diese erste Elektrodenfläche im Sinne der Erfindung schirmt die Einflüsse der induktiven Elemente voneinander ab. In diesem Ausführungsbeispiel werden also mehrere Elektrodenflächen gebildet, wobei eine erste Elektrodenfläche 41 eine Shield-Funktion zur Unterbindung von gegenseitigen Beeinflussungen der induktiven Elemente bewirkt und eine zweite Elektrodenfläche 40 als kapazitive Sensorelektrode wirkt.

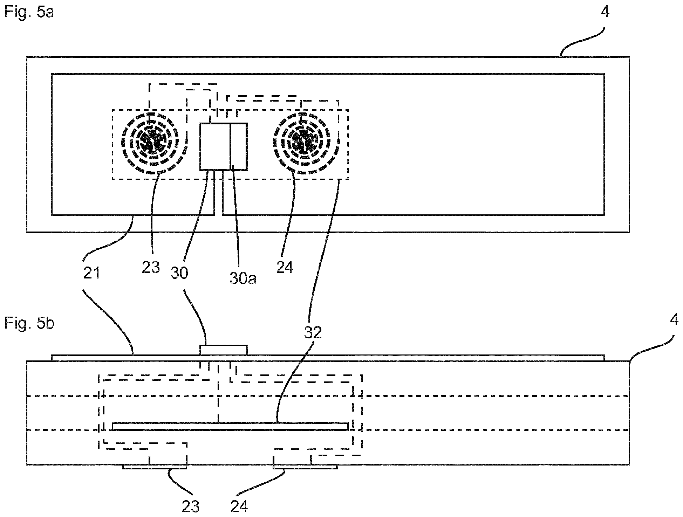

Die Figuren 5a und 5b zeigen eine weitere Ausführungsform der Erfindung. Die Ausführungsform ist hinsichtlich der Auswahl und Anzahl der Komponenten ähnlich dem Ausführungsbeispiel der Figuren 2a und 2b.

Auf der ersten Ebene der Mehrlagenplatine 4 ist wiederum eine Nahfeldspule 21 der Sende-/Empfangseinrichtung ausgebildet. Diese Nahfeldspule 21 ist mit der Steuerschaltung 20 gekoppelt. Die Sende-/Empfangseinrichtung weist Komponenten 30a auf, die mit der Steuerschaltung 30 integriert sind, zusätzlich zu der Nahfeldspule 21. Die Sende-/Empfangseinrichtung und die Steuerschaltung 20 können auch als gekoppelte, getrennte elektronische Komponenten auf der Mehrlagenplatine 4 angeordnet sein.

In einer zweiten Ebene der Mehrlagenplatine 4, nämlich der unteren Deckseite der Mehrlagenplatine, sind zwei gedruckte spiralförmige Spulenwindungen 23 und 24 als induktive Sensoren angeordnet. Diese induktiven Sensoren 23 und 24 sind mit der Steuerschaltung 20 gekoppelt. Die Steuerschaltung 20 steuert die induktiven Sensoren 23 und 24 an, um Veränderungen von deren Induktivität bei Verformung des Gehäuses des Fahrzeugtürgriffes 1 zu erfassen.

Auf einer Ebene zwischen der ersten Ebene der Mehrlagenplatine 4 und der zweiten Ebene der Mehrlagenplatine 4, also zwischen den Deckseiten der Mehrlagenplatine, ist wiederum eine Elektrodenfläche 32 angeordnet, die ebenfalls mit der Steuerschaltung 30 gekoppelt ist. Die Steuerschaltung 30 gibt das Potenzial der Elektrodenfläche 32 vor. Diese Elektrodenfläche 32 wirkt bei geeigneter Potentialvorgabe als Schirmelektrode, welche die gegenseitige Beeinflussung der Induktivitäten der Nahfeldspule 21 einerseits und der induktiven Sensoren 23 und 24 anderseits vermindert.

Gegenüber dem Ausführungsbeispiel in den Figuren 2a und 2b ist jedoch in dieser Ausführungsform der Flächenbereich oberhalb der Elektrodenfläche 32 genutzt, um die Steuerschaltung 30 anzuordnen. Der von der Elektrodenfläche 32 überdeckte Flächenbereich der Platine 4 wird also auf der einen (unteren) Seite für die Sensoren 23 und 24 genutzt, auf der anderen (oberen) Seite für die Steuerschaltung 30, welch durch die Elektrodenfläche 32 vor den Feldern der Sensoren abgeschirmt ist. Auf diese Weise ist eine verbesserte Bauraumnutzung der Platine 4 möglich.

## Patentansprüche

1. Fahrzeugtürgriff (1) mit einer Sensorelektronik und einer Sende-/Empfangseinrichtung,
wobei Komponenten der Sensorelektronik und Komponenten der Sende-/Empfangseinrichtung auf einer gemeinsamen Mehrlagenplatine (4) ausgebildet sind, wobei die Mehrlagenplatine (4) in dem Fahrzeugtürgriff (1) in einem Abschnitt angeordnet ist, der für einen Bediener als umgreifbare oder hintergreifbare Handhabe (2) ausgebildet ist,
wobei eine Steuerschaltung (20) mit der Sensorelektronik und der Sende-/Empfangseinrichtung gekoppelt ist,
wobei die Sende-/Empfangseinrichtung eine Komponente in Gestalt einer Nahfeldspule (21) aufweist, die auf einer ersten Ebene der Mehrlagenplatine (4) ausgebildet ist,
wobei die Sensorelektronik wenigstens einen induktiven Sensor (23, 24) aufweist, der auf einer zweiten Ebene der Mehrlagenplatine (4) ausgebildet ist,
wobei eine erste Elektrodenfläche (22; 30; 41) auf der Mehrlagenplatine ausgebildet ist, die von der Nahfeldspule (21) in einer Projektion in Richtung senkrecht zu den Lagen der Mehrlagenplatine umschlossen ist,
wobei die erste Elektrodenfläche (22; 30; 41) den wenigstens einen induktiven Sensor in einer Projektion in Richtung senkrecht zu den Lagen der Mehrlagenplatine (4) zu mehr als 50% abdeckt,
wobei die erste Elektrodenfläche (22; 30; 41) auf der ersten Ebene der Mehrlagenplatine oder einer Ebene zwischen der ersten Ebene und der zweiten Ebene ausgebildet ist.

2. Fahrzeugtürgriff nach Anspruch 1, wobei die erste Ebene eine erste äußere Deckebene der Mehrlagenplatine (4) ist und die zweite Ebene die zweite äußere Deckebene der Mehrlagenplatine ist, wobei die erste äußere Deckebene an einer der zweiten äußeren Deckebene abgewandten Seite der Mehrlagenplatine angeordnet ist.

3. Fahrzeugtürgriff nach Anspruch 1 oder 2, wobei die erste Elektrodenfläche mit der Steuerschaltung gekoppelt ist, wobei ein elektrisches Potenzial der ersten Elektrodenfläche von der Steuerschaltung vorgebbar ist.

4. Fahrzeugtürgriff nach Anspruch 3, wobei die erste Elektrodenfläche mit der Steuerschaltung als kapazitive Sensorelektrode wirksam gekoppelt ist.

5. Fahrzeugtürgriff nach Anspruch 4, wobei die erste Elektrodenfläche (30) eine Mehrzahl von beabstandeten Leiterbahnen aufweist, die sich in derselben Fläche erstrecken und jeweils an einem Ende galvanisch zur Bildung der ersten Elektrodenfläche gekoppelt sind.

6. Fahrzeugtürgriff nach Anspruch 5, wobei die beabstandeten Leiterbahnen in einer Kammstruktur parallel zueinander angeordnet und durch einen Verbindungsleiter miteinander gekoppelt sind.

7. Fahrzeugtürgriff nach einem der Ansprüche 1 bis 3, wobei in der zweiten Ebene der Mehrlagenplatine eine zweite Elektrodenfläche (40) ausgebildet ist, welche um den wenigstens einen induktiven Sensor (23, 24) herum angeordnet ist,
wobei der Flächenbereich der zweiten Elektrodenfläche von der Spulenwindung in einer Projektion in Richtung senkrecht zu den Lagen der Mehrlagenplatine umschlossen ist,
wobei die zweite Elektrodenfläche mit der Steuerschaltung als kapazitive Sensorelektrode wirksam gekoppelt ist.

8. Fahrzeugtürgriff nach einem der vorangehenden Ansprüche, wobei der wenigstens eine induktive Sensor (23, 24) mit einer spiralförmigen Spulenwicklung ausgebildet ist, die als gedruckte Leiterbahn auf der zweiten Ebene der Mehrlagenplatine (4) ausgebildet ist.

9. Fahrzeugtürgriff nach einem der vorangehenden Ansprüche, wobei die erste Elektrodenfläche (32) die Steuerschaltung in einer Projektion in Richtung senkrecht zu den Lagen der Mehrlagenplatine (4) wenigstens teilweise abdeckt.

## Claims

1. Vehicle door handle (1) with sensor electronics and a transmitting/receiving device,
wherein components of the sensor electronics and components of the transmitting/receiving device are formed on a common multilayer board (4), wherein the multilayer board (4) is arranged in the vehicle door handle (1) in a section which is designed for an operator as a handle (2) which can be gripped around or behind,
wherein a control circuit (20) is coupled to the sensor electronics and the transmitting/receiving device,
wherein the transmitting/receiving device has a component in the guise of a near-field coil (21) which is formed on a first plane of the multilayer printed circuit board (4)
wherein the sensor electronics comprises at least one inductive sensor (23, 24) formed on a second plane of the multilayer board (4)
wherein a first electrode area (22; 30; 41) is formed on the multilayer board, which is enclosed by the near-field coil (21) in a projection in a direction perpendicular to the layers of the multilayer board,
wherein the first electrode area (22; 30; 41) covers the at least one inductive sensor by more than 50% in a projection in a direction perpendicular to the layers of the multilayer board (4),
wherein the first electrode surface (22; 30; 41) is formed on the first plane of the multilayer board or a plane between the first plane and the second plane.

2. Vehicle door handle of claim 1, wherein the first plane is a first outer cover plane of the multilayer board (4) and the second plane is the second outer cover plane of the multilayer board, wherein the first outer cover plane is disposed on a side of the multilayer board opposite to the second outer cover plane.

3. Vehicle door handle of claim 1 or 2, wherein the first electrode surface is coupled to the control circuit, wherein an electrical potential of the first electrode surface is predeterminable by the control circuit.

4. Vehicle door handle of claim 3, wherein the first electrode surface is operatively coupled to the control circuit as a capacitive sensing electrode.

5. Vehicle door handle of claim 4, wherein the first electrode surface (30) comprises a plurality of spaced apart conductive traces extending in the same surface and each galvanically coupled at one end to form the first electrode surface.

6. Vehicle door handle according to claim 5, wherein the spaced conductive traces are arranged in a comb structure parallel to each other and coupled to each other by a connecting conductor.

7. Vehicle door handle according to any one of claims 1 to 3, wherein a second electrode area (40) is formed in the second plane of the multilayer board, which is arranged around the at least one inductive sensor (23, 24),
wherein the surface area of the second electrode surface is enclosed by the coil winding in a projection in the direction perpendicular to the layers of the multilayer board,
wherein the second electrode area is operatively coupled to the control circuit as a capacitive sensor electrode.

8. Vehicle door handle according to any one of the preceding claims, wherein the at least one inductive sensor (23, 24) is formed with a spiral coil winding formed as a printed circuit track on the second layer of the multilayer board (4).

9. Vehicle door handle according to any one of the preceding claims, wherein the first electrode area (32) at least partially covers the control circuit in a projection in a direction perpendicular to the layers of the multilayer board (4).

## Revendications

1. Poignée de porte de véhicule (1) avec une électronique de détection et un dispositif d'émission/réception,
des composants de l'électronique de capteur et des composants du dispositif d'émission/réception étant formés sur une platine multicouche commune (4), la platine multicouche (4) étant disposée dans la poignée de porte de véhicule (1) dans une section qui est conçue comme une poignée (2) pouvant être saisie par le haut ou par derrière par un opérateur,
dans laquelle un circuit de commande (20) est couplé à l'électronique du capteur et au dispositif d'émission/réception,
dans laquelle le dispositif d'émission/réception présente un composant sous la forme d'une bobine de champ proche (21) qui est réalisée sur un premier plan de la platine multicouche (4),
l'électronique de capteur présentant au moins un capteur inductif (23, 24) qui est formé sur un deuxième plan de la platine multicouche (4),
dans laquelle une première surface d'électrode (22 ; 30 ; 41) est formée sur la platine multicouche qui est entourée par la bobine de champ proche (21) dans une projection dans la direction perpendiculaire aux couches de la platine multicouche,
dans laquelle la première surface d'électrode (22 ; 30 ; 41) recouvre ledit au moins un capteur inductif à plus de 50 % dans une projection dans la direction perpendiculaire aux couches de la platine multicouche (4),
dans laquelle la première surface d'électrode (22 ; 30 ; 41) est formée sur le premier plan de la platine multicouche ou un plan entre le premier plan et le deuxième plan.

2. Poignée de porte de véhicule selon la revendication 1, dans laquelle le premier plan est un premier plan de couverture extérieur de la platine multicouche (4) et le deuxième plan est le deuxième plan de couverture extérieur de la platine multicouche, le premier plan de couverture extérieur étant disposé sur un côté de la platine multicouche opposé au deuxième plan de couverture extérieur.

3. Poignée de porte de véhicule selon la revendication 1 ou 2, dans laquelle la première surface d'électrode est couplée au circuit de commande, un potentiel électrique de la première surface d'électrode pouvant être prédéfini par le circuit de commande.

4. Poignée de porte de véhicule selon la revendication 3, dans laquelle la première surface d'électrode est couplée de manière opérationnelle au circuit de commande en tant qu'électrode de détection capacitive.

5. Poignée de porte de véhicule selon la revendication 4, dans laquelle la première surface d'électrode (30) comprend une pluralité de pistes conductrices espacées qui s'étendent dans la même surface et qui sont chacune couplées galvaniquement à une extrémité pour former la première surface d'électrode.

6. Poignée de porte de véhicule selon la revendication 5, dans laquelle les pistes conductrices espacées sont disposées parallèlement les unes aux autres dans une structure en peigne et sont couplées entre elles par un conducteur de liaison.

7. Poignée de porte de véhicule selon l'une quelconque des revendications 1 à 3, dans laquelle une deuxième surface d'électrode (40) est formée dans le deuxième plan de la platine multicouche et est disposée autour de l'au moins un capteur inductif (23, 24),
dans lequel la zone de surface de la seconde surface d'électrode est entourée par l'enroulement de bobine dans une projection dans la direction perpendiculaire aux couches de la carte multicouche,
la deuxième surface d'électrode étant couplée de manière opérationnelle au circuit de commande en tant qu'électrode de détection capacitive.

8. Poignée de porte de véhicule selon l'une quelconque des revendications précédentes, dans laquelle ledit au moins un capteur inductif (23, 24) est réalisé avec un enroulement de bobine en forme de spirale qui est réalisé sous la forme d'une piste conductrice imprimée sur le deuxième plan de la platine multicouche (4).

9. Poignée de porte de véhicule selon l'une quelconque des revendications précédentes, dans laquelle la première surface d'électrode (32) recouvre au moins partiellement le circuit de commande dans une projection dans une direction perpendiculaire aux couches de la carte de platine multicouche (4) .
